# EUROPÄISCHE PATENTSCHRIFT

(11) **EP 2 305 015 B1**
(45) Veröffentlichungstag und Bekanntmachung des Hinweises auf die Patenterteilung: **14.03.2012**
(21) Anmeldenummer: 09780176.5
(22) Anmeldetag: 06.07.2009
(51) Int. Cl.: H05K 5/06, H05K 3/28

(54) **ABDICHTRAHMEN SOWIE VERFAHREN ZUM ABDECKEN EINES BAUTEILS**
SEALING FRAME AND METHOD FOR COVERING A COMPONENT
CADRE D'ÉTANCHÉITÉ ET PROCÉDÉ DE RECOUVREMENT D'UN COMPOSANT

(30) Priorität: 24.07.2008 DE 102008040676
(43) Veröffentlichungstag der Anmeldung: 06.04.2011
(73) Patentinhaber: Robert Bosch GmbH, 70442 Stuttgart (DE)
(72) Erfinder: GEISE, Stephan, 59602 Ruethen (DE)
(86) Internationale Anmeldenummer: PCT/EP2009/058490
(87) Internationale Veröffentlichungsnummer: WO 2010/009970

(56) Entgegenhaltungen:
- EP-B1- 0 539 555
- DE-A1- 4 405 710
- DE-A1-102005 003 125
- US-A- 5 795 799

## Beschreibung

### Stand der Technik

Die Erfindung betrifft einen Abdichtrahmen zum Begrenzen einer Fläche eines Bauteils, die mit einer Formmasse abgedeckt werden soll. Weiterhin betrifft die Erfindung ein Verfahren zum Abdecken eines Bauteils mit einer Formmasse unter Verwendung des Abdichtrahmens.

Um Bauteile vor äußeren Umwelteinflüssen oder Medieneinflüssen zu schützen, ist es üblich, das Bauteil mit einer Formmasse abzudecken. Als Formmasse werden hierbei üblicherweise Epoxid-Niederdruckpressmassen, die auf eine zu schützende Fläche des Bauteils aufgetragen werden, eingesetzt.

Insbesondere bei elektronischen Bauelementen, beispielsweise mit elektronischen Funktionselementen, beispielsweise Halbleiterbauelementen wie Chips, werden zunehmend höhere Anforderungen bezüglich deren Temperaturbeständigkeit, Medienbeständigkeit, Leistungserhöhung und Zuverlässigkeit, insbesondere bei sicherheitsrelevanten Anwendungen, gestellt. Durch das Abdecken mit der Formmasse wird erzielt, dass Medien aus der Umgebung nicht mit den Bauelementen in Kontakt treten können und diese schädigen können.

Um elektronische Bauelemente mit Stanzgittern gratfrei abzudichten, werden derzeit umlaufende Stanzgitterverbindungen verwendet, die jedoch nach dem Aufbringen der Epoxid-Niederdruckpressmasse aufwändig ausgestanzt werden müssen. Hierdurch kann die Abdeckung mit der Niederdruckpressmasse beschädigt werden.

Durch Abrasion der Formmassen an den Werkzeugkanten lässt sich eine Gratbildung während des Herstellprozesses nicht verhindern. Diese kann jedoch in nachfolgenden Prozessschritten zu Verunreinigungen führen. Zur Vermeidung der Gratbildung wurde daher ein fest mit der Formmasse verbundener Rahmen eingesetzt, der das Bauteil umschließt. Hierdurch wird jedoch der benötigte Bauraum für das Bauteil erhöht. Zudem muss für jedes Bauteil ein neuer Rahmen hergestellt werden.

In US 5 795 799 wird ein Verfahren zum Abdecken eines Bauteils mit einer Formmasse unter Verwendung eines Abdichrahmens gezeigt.

### Offenbarung der Erfindung

### Vorteile der Erfindung

Ein erfindungsgemäß ausgebildeter Abdichtrahmen zum Begrenzen einer Fläche eines Bauteils, die mit einer Formmasse abgedeckt werden soll, umfasst ein oberes Rahmenteil und ein unteres Rahmenteil, die lösbar miteinander verbunden werden können. Das mit der Formmasse abzudeckende Bauteil ist durch das obere Rahmenteil und das untere Rahmenteil derart umschließbar, dass eine von dem Abdichtrahmen und dem Bauteil gebildete Kavität für die in die Kavität eingegossene Formmasse abgedichtet ist.

Durch die Ausgestaltung des Abdichtrahmens mit einem oberen Rahmenteil und einem unteren Rahmenteil, die lösbar miteinander verbunden werden können, kann der Rahmen insbesondere bei der Serienfertigung von Bauteilen für gleichartige Bauteile wiederverwendet werden. Dadurch, dass der Rahmen nach dem Abdecken des Bauteils mit der Formmasse wieder entfernt werden kann, erhöht der Rahmen nicht den Bauraum, der für das Bauteil benötigt wird. Zudem lässt sich durch die Verwendung des Rahmens eine gratfreie Abdeckung des Bauteils erzielen.

Um ein Lösen des Abdichtrahmens nach dem Einbringen der Formmasse zu ermöglichen, ist es bevorzugt, den Abdichtrahmen aus einem thermoplastischen Kunststoff zu bilden, der sich nicht mit der Formmasse verbindet. Durch die Verwendung eines thermoplastischen Kunststoffs, der sich nicht mit der Formmasse verbindet, ist es nicht erforderlich, ein zusätzliches Trennmittel auf den Abdichtrahmen aufzubringen, um zu verhindern, dass die Formmasse sich mit dem Abdichtrahmen verbindet. Ein leichteres Abnehmen des Abdichtrahmens wird hierdurch ermöglicht.

Um die Formmasse auszuhärten, wird das mit dem Abdichtrahmen versehene Bauteil üblicherweise erwärmt. Das Erwärmen führt zu einem Ausdehnen des thermoplastischen Kunststoffs des Abdichtrahmens. Beim Abkühlen ziehen sich sowohl der Abdichtrahmen als auch die Formmasse zusammen. Hierdurch entsteht ein Spalt zwischen der Formmasse und dem thermoplastischen Kunststoff, der sich nicht mit der Formmasse verbunden hat. Dies erleichtert ebenfalls das Abnehmen des Abdichtrahmens nach dem Abdecken der Fläche mit der Formmasse.

Als thermoplastische Kunststoffe, aus denen der Abdichtrahmen gefertigt wird, eignen sich zum Beispiel Perfluoralkoxy-Copolymere. Welche thermoplastischen Kunststoffe jeweils geeignet sind, ist auch abhängig von der eingesetzten Formmasse.

Die Verwendung eines thermoplastischen Kunststoffs für den Abdichtrahmen hat weiterhin den Vorteil, dass der Abdichtrahmen auf einfache Weise durch ein Spritzgussverfahren hergestellt werden kann. Auch ist es möglich, zum Beispiel bei einem Produktionswechsel oder einer Änderung der Form des mit der Formmasse abzudeckenden Bauteils den Rahmen einzuschmelzen und aus dem eingeschmolzenen Material einen neuen Abdichtrahmen zu fertigen.

In einer Ausführungsform umfasst der Abdichtrahmen Clips, mit denen das obere Rahmenteil und das untere Rahmenteil miteinander verbunden werden können. Hierbei ist es zum Beispiel möglich, dass die Clips drehbar am oberen Rahmenteil oder am unteren Rahmenteil befestigt sind und mit einer am jeweils anderen Rahmenteil angebrachten Vorrichtung verbunden werden können. Alternativ ist es auch möglich, Clipverschlüsse vorzusehen, die nicht mit einem der Rahmenteile fest verbunden sind. Alternativ zu Clipverschlüssen eignet sich jedoch auch jede beliebige andere lösbare Verbindung zum Verbinden des oberen Rahmenteils mit dem unteren Rahmenteil. So können zum Beispiel auch Schrauben oder, bei runden Bauteilen, ein Bajonettverschluss eingesetzt werden. Auch jede beliebige andere lösbare Verbindung des oberen Rahmenteils mit dem unteren Rahmenteil, die dem Fachmann bekannt ist, kann eingesetzt werden. Aufgrund der einfachen und schnellen Befestigung sind jedoch Clipverschlüsse bevorzugt.

Wenn Teile des Bauteils nicht von der Formmasse abgedeckt werden sollen, zum Beispiel bei einem Bauteil mit einem Stanzgitter Bereiche des Stanzgitters, die beispielsweise als elektrische Anschlüsse dienen, ist es bevorzugt, wenn zwischen dem oberen und dem unteren Rahmenteil des Abdichtrahmens Durchlässe ausgebildet sind, durch die die Teile des Bauteils geführt werden können, die nicht von der Formmasse abgedeckt werden sollen. Die Durchlässe sind dabei vorzugsweise so gestaltet, dass die Teile des Bauteils, die durch die Durchlässe geführt werden, dicht an den Durchlässen anliegen, so dass die Formmasse nicht durch die Durchlässe austreten kann. Für eine einfache Montage des Abdichtrahmens ist es bevorzugt, wenn die Durchlässe in Form von Aussparungen im oberen Rahmenteil und/oder im unteren Rahmenteil ausgebildet sind.

Um eine exakte Positionierung des Rahmens in einem Gießwerkzeug zu erhalten, ist es bevorzugt, wenn am Abdichtrahmen Cliphalterungen angebracht sind, mit denen der Abdichtrahmen mit dem Bauteil im Gießwerkzeug positioniert wird. Neben Cliphalterungen eignen sich jedoch auch beliebige andere Vorrichtungen, mit denen eine exakte Positionierung des Abdichtrahmens samt vom Abdichtrahmen umschlossenen Bauteil im Gießwerkzeug realisiert werden kann.

Ein erfindungsgemäßes Verfahren zum Abdecken eines Bauteils mit einer Formmasse unter Verwendung des Abdichtrahmens umfasst folgende Schritte:
(a) Einlegen des Bauteils in das obere Rahmenteil und untere Rahmenteil und Verbinden des oberen und unteren Rahmenteils zum Abdichtrahmen, so dass sich eine Kavität ausbildet, die von dem Bauteil und dem oberen Rahmenteil umschlossen ist,
(b) Einbringen einer Formmasse in die Kavität und Aushärten der Formmasse,
(c) Entfernen des Rahmens durch Lösen der Verbindung von oberem und unterem Rahmenteil und Entnahme des Bauteils.

Um das Bauteil in das obere und untere Rahmenteil einzulegen, wird üblicherweise das Bauteil auf das untere Rahmenteil aufgelegt und darauf das obere Rahmenteil positioniert. Anschließend werden das untere und das obere Rahmenteil miteinander verbunden. Auf diese Weise bildet das Bauteil einen Boden der Kavität und das obere Rahmenteil die Umrandung der Kavität.

Zum Positionieren des Bauteils im oberen und unteren Rahmenteil ist es bevorzugt, wenn am unteren Rahmenteil und am oberen Rahmenteil jeweils eine Nut ausgebildet ist, in die das Bauteil eingelegt wird. Wenn das Bauteil Bereiche umfasst, die nicht von der Formmasse abgedeckt werden sollen, beispielsweise Teile eines Stanzgitters, so ist es im Allgemeinen bereits ausreichend, die Bereiche, die nicht von der Formmasse abgedeckt werden sollen, durch entsprechende Aussparungen im unteren und/oder oberen Rahmenteil zu führen und auf diese Weise das Bauteil zu positionieren.

Die Formmasse wird im Allgemeinen in einem Gießwerkzeug in die Kavität eingebracht. Hierzu wird das Bauteil zunächst in das Gießwerkzeug eingelegt. Eine genaue Positionierung des Bauteils mit dem Abdichtrahmen lässt sich zum Beispiel durch Positionierungshilfen, beispielsweise die zuvor bereits erwähnten Cliphalterungen, erzielen. Sobald das Bauteil mit dem Abdichtrahmen in das Gießwerkzeug eingelegt ist, wird das Werkzeug erwärmt. Alternativ ist es auch möglich, dass das Bauteil samt Abdichtrahmen in ein bereits warmes Gießwerkzeug eingelegt wird. Durch das Erwärmen dehnen sich das untere Rahmenteil und das obere Rahmenteil aus und legen sich auf diese Weise dicht an das Bauteil an. Eine dichte Verbindung zwischen Bauteil und Abdichtrahmen wird erzielt. Die Formmasse kann somit nicht durch Leckagekanäle zwischen dem oberen Rahmenteil oder unteren Rahmenteil und dem Bauteil austreten. Hierdurch wird ein gratfreies Einbringen der Formmasse ermöglicht.

Insbesondere wenn das Bauteil Teile umfasst, die nicht von der Formmasse abgedeckt werden sollen, beispielsweise Teile eines Stanzgitters, die beispielsweise als elektrische Anschlüsse dienen, und die durch Durchlässe des Abdichtrahmens geführt werden, legen sich das untere Rahmenteil und das obere Rahmenteil durch das Ausdehnen aufgrund der Erwärmung an die durch das Rahmenteil geführten Teile an, so dass auch hier eine flüssigkeitsdichte Verbindung entsteht.

Das Einbringen der Formmasse in die Kavität erfolgt durch ein übliches, dem Fachmann bekanntes Verfahren. Bevorzugt wird die Formmasse durch ein Gießverfahren, insbesondere ein Niederdruckgießverfahren, in die Kavität eingebracht. Die Formmasse liegt hierzu üblicherweise flüssig vor. Nach dem Einbringen der Formmasse in die Kavität wird die Formmasse ausgehärtet. Die eingesetzte Formmasse kann zum Beispiel strahlungshärtend oder wärmeaushärtend sein. Bevorzugt ist die Formmasse wärmeaushärtend.

Als Formmasse eignet sich zum Beispiel eine Niederdruckpressmasse, insbesondere eine Epoxid-Niederdruckpressmasse.

Das Bauteil, das durch das erfindungsgemäße Verfahren mit der Formmasse abgedeckt wird, umfasst vorzugsweise eine bestückte Leiterplatte. Eine solche Leiterplatte ist üblicherweise mit Halbleiterbauelementen bestückt. Jedoch können auch beliebige andere elektronische Bauelemente, die üblicherweise auf eine Leiterplatte aufgesetzt werden, beispielsweise Widerstände, umfasst sein.

In einer weiteren Ausführungsform umfasst das Bauteil zusätzlich ein Stanzgitter.

Wenn das Bauteil ein Stanzgitter umfasst, ist es bevorzugt, wenn zunächst das Stanzgitter in das untere Rahmenteil eingelegt wird. Wenn Teile des Stanzgitters nicht von der Formmasse abgedeckt werden sollen, sind im unteren Rahmenteil Aussparungen vorgesehen, die als Durchlässe für die nicht abzudeckenden Teile des Stanzgitters dienen. An diesen Auslässen wird das Stanzgitter eingelegt. In einem nächsten Schritt wird das Rahmenoberteil mit dem Rahmenunterteil verbunden. Dies erfolgt zum Beispiel durch Anclipsen des Rahmenoberteils an das Rahmenunterteil. Nach dem Befestigen des Stanzgitters im Abdichtrahmen kann in einem nächsten Prozessschritt eine Leiterplatte an das Stanzgitter angelötet werden und bestückt werden. Alternativ ist es auch möglich, eine bereits bestückte Leiterplatte mit dem Stanzgitter zu verbinden.

Wenn ein Stanzgitter für mehrere Module vorgesehen ist, so ist es möglich, bereits mehrere Module jeweils mit dem Abdichtrahmen auf die vorstehend beschriebene Weise zu versehen. Nach dem Anbringen des Abdichtrahmens und der Leiterplatte werden in diesem Fall jeweils einzelne Module, den Abdichtrahmen, das Stanzgitter und die Leiterplatte umfassend, von einem Stanzgitterband, aus dem das Stanzgitter für die einzelnen Module gefertigt ist, abgetrennt. Nach dem Abtrennen der einzelnen Module wird das Modul in das Gießwerkzeug eingelegt, in dem die Formmasse eingebracht wird.

Nach dem Aushärten der Formmasse wird das Modul aus dem Gießwerkzeug entnommen. Beim Abkühlen ziehen sich, wie vorstehend bereits beschrieben, der Abdichtrahmen und die Formmasse zusammen. Hierdurch entsteht ein Spalt zwischen Formmasse und Abdichtrahmen. Der Rahmen kann auf einfache Weise durch Lösen der Verbindung abgenommen werden und für ein weiteres Modul wiederverwendet werden.

### Kurze Beschreibung der Zeichnungen

Ausführungsbeispiele der Erfindung sind in den Zeichnungen dargestellt und in der nachfolgenden Beschreibung näher erläutert.

Es zeigen
- Figur 1: eine schematische Darstellung eines Abdichtrahmens mit Stanzgitter und Leiterplatte;
- Figur 2: eine schematische Darstellung des Abdichtrahmens mit Stanzgitter gemäß Figur 1 mit eingebrachter Formmasse.

### Ausführungsformen der Erfindung

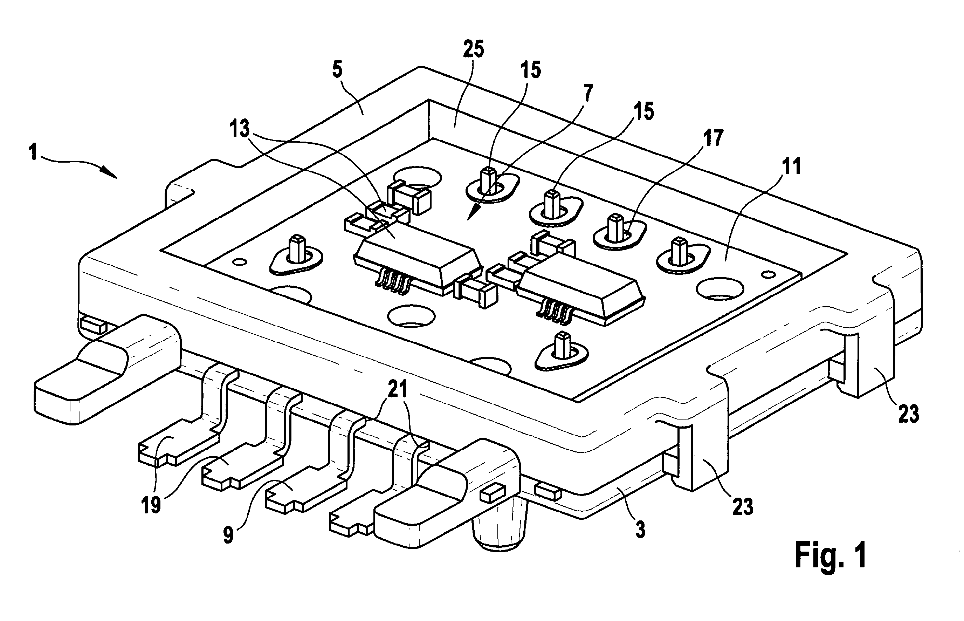

Figur 1 zeigt eine schematische Darstellung eines Abdichtrahmens mit eingeclipstem Stanzgitter und Leiterplatte.

Ein erfindungsgemäß ausgebildeter Abdichtrahmen 1 umfasst ein unteres Rahmenteil 3 und ein oberes Rahmenteil 5. Das untere Rahmenteil 3 und das obere Rahmenteil 5 sind zum Abdichtrahmen 1 miteinander verbunden.

Das untere Rahmenteil 3 und das obere Rahmenteil 5 sind vorzugsweise aus einem thermoplastischen Kunststoff gefertigt. Durch die Verwendung eines thermoplastischen Kunststoffs lassen sich das untere Rahmenteil 3 und das obere Rahmenteil 5 auf einfache Weise durch ein Spritzgießverfahren herstellen. Der thermoplastische Kunststoff, aus dem das untere Rahmenteil 3 und das obere Rahmenteil 5 gefertigt werden, ist vorzugsweise ein Kunststoff, da er sich nicht mit dem Material der Formmasse verbindet. Geeignete thermoplastische Kunststoffe sind zum Beispiel Perfluoralkoxy-Copolymere.

Der Abdichtrahmen 1 umschließt ein Bauteil 7. In der hier dargestellten Ausführungsform ist das Bauteil 7 eine mit einem Stanzgitter 9 verbundene Leiterplatte 11. Die Leiterplatte 11 ist mit elektronischen Bauelementen 13 bestückt. Elektronische Bauelemente sind zum Beispiel Halbleiterbauelemente wie Chips oder Transistoren. Auch können die elektronischen Bauelemente 13 beispielsweise Widerstände oder beliebige andere elektronische Bauelemente sein, mit denen eine Leiterplatte 11 üblicherweise bestückt wird.

Die Verbindung der Leiterplatte 11 mit dem Stanzgitter 9 erfolgt auf eine beliebige, dem Fachmann bekannte Weise. So ist es zum Beispiel möglich, dass die Leiterplatte 11 mit dem Stanzgitter 9 verlötet wird. Auch ein Aufklemmen der Leiterplatte 11 auf das Stanzgitter 9 ist möglich. Weiterhin ist es auch möglich, dass die Leiterplatte 11 nur auf das Stanzgitter 9 aufgelegt wird. Um die Leiterplatte 11 exakt auf dem Stanzgitter 9 zu positionieren, ist es zum Beispiel üblich, dass das Stanzgitter Stifte 15 umfasst, die durch entsprechende Öffnungen 17 in der Leiterplatte 11 geführt werden.

Um das Stanzgitter 9 und die Leiterplatte 11 im Abdichtrahmen 1 zu positionieren, ist es zum Beispiel möglich, zunächst das Stanzgitter 9 in das untere Rahmenteil 3 einzulegen. Wenn das Stanzgitter 9, wie in Figur 1 dargestellt, Anschlüsse 19 aufweist, die aus dem Abdichtrahmen 1 herausragen, so ist es vorteilhaft, wenn im unteren Rahmenteil 3 Aussparungen 21 ausgebildet sind, durch die die Anschlüsse 19 geführt werden. Durch das Einlegen der Anschlüsse 19 in die Aussparungen 21 erfolgt zudem eine exakte Positionierung des Stanzgitters 9 im unteren Rahmenteil 3. Nach dem Einlegen des Stanzgitters 9 in das untere Rahmenteil 3 wird das untere Rahmenteil 3 mit dem oberen Rahmenteil 5 verbunden. Das Verbinden des oberen Rahmenteils 5 mit dem unteren Rahmenteil 3 erfolgt zum Beispiel, wie hier dargestellt, mit Clipverschlüssen 23. Alternativ ist es jedoch auch möglich, das untere Rahmenteil mit dem oberen Rahmenteil zum Beispiel durch Verwendung von Schrauben oder anderen lösbaren Verbindungsmitteln zu verbinden. Insbesondere bei einem runden Bauteil ist es zum Beispiel auch möglich, das untere Rahmenteil 3 mit dem oberen Rahmenteil 5 mit einem Bajonettverschluss zu verbinden.

Nach dem Verbinden des unteren Rahmenteils 3 mit dem oberen Rahmenteil 5 wird die Leiterplatte 11 mit dem Stanzgitter 9 verbunden und mit den elektronischen Bauelementen 13 bestückt. Neben den elektronischen Bauelementen 13 können zusätzlich auch mechanische Bauteile, beispielsweise Kühler oder Ähnliches, vorgesehen sein.

Alternativ ist es auch möglich, die Leiterplatte 11 zunächst mit den elektronischen Bauelementen 13 zu bestücken und erst nach dem Bestücken mit dem Stanzgitter 9 zu verbinden. In einer weiteren alternativen Ausführungsform ist es ebenfalls möglich, zunächst Stanzgitter 9 und bestückte Leiterplatte 11 zu verbinden und anschließend das mit der Leiterplatte 11 verbundene Stanzgitter 9 in dem aus unterem Rahmenteil 3 und oberem Rahmenteil 5 zusammengefügten Abdichtrahmen 1 zu positionieren.

Wenn das mit der Formmasse abzudeckende Bauteil kein Stanzgitter 9 umfasst, ist es alternativ zum Beispiel möglich, dass im unteren Rahmenteil 3 und/oder im oberen Rahmenteil 5 eine Nut ausgebildet ist, in die das Bauteil eingelegt wird. Durch das Einlegen in die Nut erfolgt die korrekte Positionierung des Bauteils im Abdichtrahmen 1.

Das Abdecken des Bauteils 7, beispielsweise der mit dem Stanzgitter 9 verbundenen Leiterplatte 11, kann sowohl an der Oberseite als auch an der Unterseite erfolgen. Üblicherweise wird zumindest die Oberseite des Bauteils 7 mit der Formmasse abgedeckt. Wenn ein Abdecken an Oberseite und Unterseite vorgesehen ist, so ist es zum Beispiel möglich, insbesondere wenn die Positionierung des Bauteils 7 im Abdichtrahmen 1 durch die Positionierung des Stanzgitters 9 erfolgt, einen Spalt zwischen der Leiterplatte 11 und dem Abdichtrahmen 1 vorzusehen. In diesem Fall kann die Formmasse durch den Spalt auf beide Seiten der Leiterplatte 11 gelangen. Alternativ ist es selbstverständlich auch möglich, die Formmasse sowohl an der Oberseite der Leiterplatte 11 als auch an der Unterseite der Leiterplatte 11 in den Abdichtrahmen einzubringen. Wenn das Abdecken des Bauteils 7 nur an der Oberseite erfolgen soll, so liegt der Abdichtrahmen 1 dicht am Bauteil 7 an und bildet so eine Kavität aus, die mit der Formmasse befüllt wird.

Nach dem Befestigen des Bauteils 7 im Abdichtrahmen 1 wird die Formmasse eingebracht, so dass das Bauteil 7 von der Formmasse abgedeckt wird. Hierzu ist es bevorzugt, den mit dem Bauteil 7 verbundenen Abdichtrahmen 1 in ein Gießwerkzeug einzulegen. Das Gießwerkzeug wird vorzugsweise beheizt. Durch das Beheizen des Gießwerkzeuges dehnen sich das untere Rahmenteil 3 und das obere Rahmenteil 5 aus und legen sich so dicht an die Wandung des Gießwerkzeugs an. Zudem wird das Bauteil 7 dicht durch den Abdichtrahmen 1 umschlossen, so dass keine Formmasse durch den Abdichtrahmen auslaufen kann. Insbesondere tritt keine Formmasse in einen Spalt zwischen dem unteren Rahmenteil 3 und dem oberen Rahmenteil 5 ein. Nach einer kurzen Aufwärmphase von maximal 5 Minuten, bevorzugt maximal 2 Minuten, insbesondere maximal 1 Minute, wird die Formmasse in das Gießwerkzeug eingebracht. Die Temperatur, auf die das Gießwerkzeug erwärmt wird, liegt vorzugsweise im Bereich von 160 bis 180 °C, insbesondere im Bereich von 160 bis 170 °C.

Nach dem Einlegen des Bauteils 7, das mit dem Abdichtrahmen 1 verbunden ist, in das Gießwerkzeug und dem Erwärmen des Abdichtrahmens 1 wird die Formmasse auf eine übliche, dem Fachmann bekannte Weise in das Werkzeug eingespritzt. Die Formmasse ist vorzugsweise eine Niederdruckpressmasse, insbesondere eine Epoxid-Niederdruckpressmasse.

Die Formmasse wird hierbei in eine Kavität 25 eingebracht, die vom oberen Rahmenteil 5 und dem Bauteil 7 begrenzt wird. Das Bauteil 7 bildet dabei den Boden der Kavität 25 und das obere Rahmenteil 5 die seitliche Begrenzung. Wenn die Formmasse auf der Oberseite und der Unterseite des Bauteiles eingebracht werden soll, so bildet die Unterseite des Bauteils 7 und das untere Rahmenteil 3 eine zweite Kavität, die ebenfalls von der Formmasse befüllt wird. Auch ist es, wie zuvor bereits beschrieben, möglich, dass zwischen dem Bauteil 7 und dem Abdichtrahmen 1 ein Spalt ausgebildet ist. In diesem Fall sind die obere Kavität 25 und die von Bauteil 7 und unterem Rahmenteil 3 begrenzte Kavität durch den Spalt miteinander verbunden.

Nach dem Einbringen der Formmasse wird die Formmasse üblicherweise im Gießwerkzeug ausgehärtet. Insbesondere bei einer wärmeaushärtenden Formmasse ist das Gießwerkzeug hierzu beheizt. Neben wärmehärtenden Formmassen ist es jedoch zum Beispiel auch möglich, strahlungshärtende Formmassen einzusetzen. In diesem Fall erfolgt eine Bestrahlung der Formmasse, beispielsweise durch UV-Licht, der Formmasse, um diese auszuhärten. Auch in diesem Fall erwärmt sich üblicherweise die Formmasse aufgrund der Härtungsreaktion.

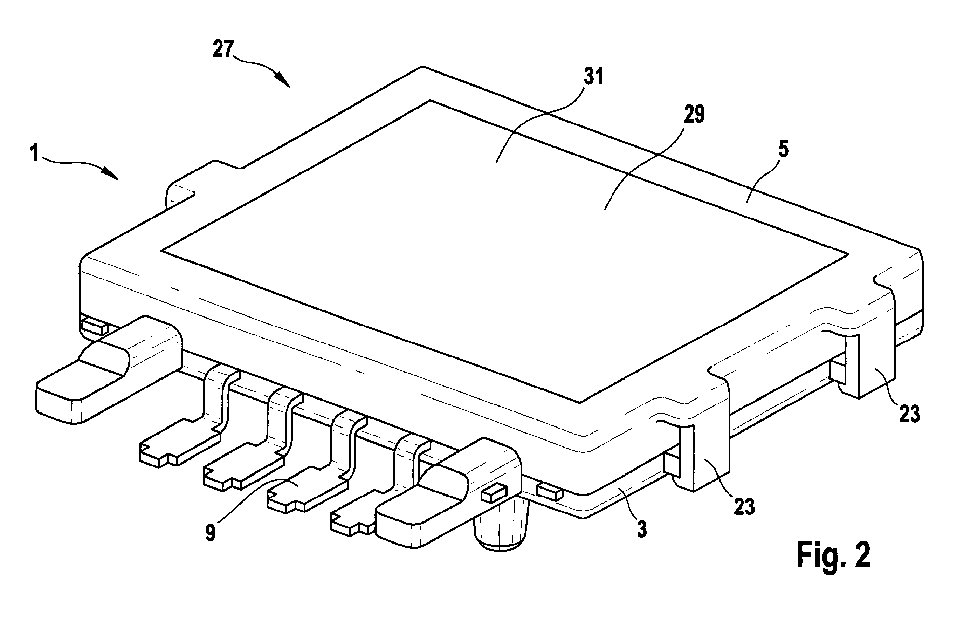

Nach dem Aushärten der Formmasse wird das so entstandene Modul 27, das in Figur 2 dargestellt ist, aus dem Spritzgießwerkzeug entnommen. Das Modul 27 umfasst dabei den Abdichtrahmen 1 aus miteinander verbundenem unteren Rahmenteil 3 und oberen Rahmenteil 5, das Stanzgitter 9, das Bauteil 7 und eine Abdeckung 29 aus der ausgehärteten Formmasse. Die Abdeckung 29 liegt dabei am Abdichtrahmen 1 an. Die Oberseite der Abdeckung 29 kann glatt sein oder eine beliebige Struktur aufweisen. Wenn die Oberseite 31 der Abdeckung 29 eine Struktur aufweist, so ist die Struktur als Negativform im Gießwerkzeug abgebildet.

Nach dem Aushärten der Formmasse kühlt das Modul 27 ab. Das Abkühlen des Moduls 27 kann dabei entweder in der Gießform erfolgen als auch nach dem Entnehmen aus der Gießform. Durch das Abkühlen schrumpfen der Abdichtrahmen 1 und die Abdeckung 29 aus der Formmasse. Hierbei ist der Grad des Schrumpfens abhängig vom Wärmeausdehnungskoeffizienten des eingesetzten Materials für Abdichtrahmen 1 und Abdeckung 29. Durch die mit der Schwindung verbundene Volumenabnahme bildet sich zwischen der Abdeckung 29 und dem Abdichtrahmen 1 ein kleiner Spalt aus. Der Spalt entsteht insbesondere daher, dass die Formmasse für die Abdeckung 29 nicht am Material des Abdichtrahmens 1 haftet. Dadurch, dass der Abdichtrahmen 1 nicht an der Abdeckung 29 aus der Formmasse haftet, lässt sich der Abdichtrahmen 1 auf einfache Weise durch Lösen der Verbindung, beispielsweise des Clipverschlusses 23, öffnen und das obere Rahmenteil 5 und untere Rahmenteil 3 können von dem mit der Abdeckung 29 versehenen Bauteil 7 entfernt werden. Nach dem Entfernen des oberen Rahmenteils 5 und des unteren Rahmenteils 3 können diese, wenn notwendig, weiter abkühlen und anschließend zum Aufbringen der Abdeckung auf ein weiteres Bauteil wieder verwendet werden.

Bauteile, die unter Verwendung des erfindungsgemäßen Abdichtrahmens 1 mit einer Abdeckung 29 versehen werden können, sind zum Beispiel Getriebe-Positionssensoren oder Hochstrommodule.

## Patentansprüche

1. Abdichtrahmen zum Begrenzen einer Fläche eines Bauteils (7), die mit einer Formmasse abgedeckt werden soll, umfassend ein oberes Rahmenteil (5) und ein unteres Rahmenteil (3), die lösbar miteinander verbunden werden können und wobei das mit der Formmasse abzudeckende Bauteil (7) durch das obere Rahmenteil (5) und das untere Rahmenteil (3) derart umschließbar ist, dass eine von dem Abdichtrahmen (1) und dem Bauteil (7) gebildete Kavität (25) für die in die Kavität (25) eingebrachte Formmasse abgedichtet ist.

2. Abdichtrahmen gemäß Anspruch 1, **dadurch gekennzeichnet, dass** der Abdichtrahmen (1) aus einem thermoplastischen Kunststoff gebildet ist, der sich nicht mit der Formmasse verbindet.

3. Abdichtrahmen gemäß Anspruch 2, **dadurch gekennzeichnet, dass** der thermoplastische Kunststoff ein Perfluoralkoxy-Copolymer ist.

4. Abdichtrahmen gemäß einem der Ansprüche 1 bis 3, **dadurch gekennzeichnet, dass** der Abdichtrahmen (1) Clipverschlüsse (23) umfasst, mit denen das obere Rahmenteil (5) und das untere Rahmenteil (3) miteinander verbunden werden können.

5. Abdichtrahmen gemäß einem der Ansprüche 1 bis 4, **dadurch gekennzeichnet, dass** zwischen dem oberen (5) und dem unteren Rahmenteil (3) Durchlässe (21) ausgebildet sind, durch die Teile (19) des Bauteils (7) geführt werden können, die nicht von der Formmasse abgedeckt werden sollen.

6. Verfahren zum Abdecken eines Bauteils mit einer Formmasse unter Verwendung eines Abdichtrahmens (1) gemäß einem der Ansprüche 1 bis 5, folgende Schritte umfassend:
(a) Einlegen des Bauteils (7) in das obere Rahmenteil (5) und untere Rahmenteil (3) und Verbinden des oberen (5) und unteren Rahmenteils (3) zum Abdichtrahmen (1), so dass sich eine Kavität (25) ausbildet, die von dem Bauteil (7) und dem oberen Rahmenteil (5) umschlossen ist,
(b) Einbringen einer Formmasse in die Kavität (25) und Aushärten der Formmasse zu einer Abdeckung (29),
(c) Entfernen des Abdichtrahmens (1) durch Lösen der Verbindung von oberem (5) und unterem Rahmenteil (3) und Entnahme des Bauteils (7).

7. Verfahren gemäß Anspruch 6, **dadurch gekennzeichnet, dass** die Formmasse eine Niederdruckpressmasse, insbesondere eine Epoxid-Niederdruckpressmasse, ist.

8. Verfahren gemäß Anspruch 6 oder 7, **dadurch gekennzeichnet, dass** das Bauteil (7) mitsamt dem Abdichtrahmen (1) zum Einbringen der Formmasse in ein Gießwerkzeug eingelegt wird.

9. Verfahren gemäß einem der Ansprüche 6 bis 8, **dadurch gekennzeichnet, dass** das Bauteil (7) und der Abdichtrahmen (1) im Gießwerkzeug erwärmt werden, so dass sich das obere Rahmenteil (5) und das untere Rahmenteil (3) ausdehnen und eine gegenüber der Formmasse dichte Verbindung zwischen Abdichtrahmen (1) und Bauteil (7) entsteht.

10. Verfahren gemäß einem der Ansprüche 6 bis 9, **dadurch gekennzeichnet, dass** das Bauteil (7) eine bestückte Leiterplatte (11) umfasst.

11. Verfahren gemäß einem der Ansprüche 6 bis 10, **dadurch gekennzeichnet, dass** das Bauteil (7) ein Stanzgitter (9) umfasst.

12. Verfahren gemäß Anspruch 11, **dadurch gekennzeichnet, dass** Teile des Stanzgitters (9), die nicht von der Formmasse abgedeckt werden sollen, durch Durchlässe (21) zwischen dem oberen (5) und dem unteren Rahmenteil (3) des Abdichtrahmens (1) geführt werden, wobei das obere (5) und das untere Rahmenteil (3) die Teile (19), die durch die Durchlässe (21) geführt werden, dicht umschließen, so dass keine Formmasse durch die Durchlässe (21) austreten kann.

## Claims

1. Sealing frame for bounding a surface of a component (7) which is to be covered with a moulding compound, comprising an upper frame part (5) and a lower frame part (3), which can be detachably connected to each other and wherein the component (7) to be covered with the moulding compound can be enclosed by the upper frame part (5) and the lower frame part (3) in such a way that a cavity (25) formed by the sealing frame (1) and the component (7) is sealed for the moulding compound introduced into the cavity (25).

2. Sealing frame according to Claim 1, **characterized in that** the sealing frame (1) is formed from a thermoplastic material that does not bond with the moulding compound.

3. Sealing frame according to Claim 2, **characterized in that** the thermoplastic material is a perfluoroalkoxy copolymer.

4. Sealing frame according to one of Claims 1 to 3, **characterized in that** the sealing frame (1) comprises clip fasteners (23), with which the upper frame part (5) and the lower frame part (3) can be connected to each other.

5. Sealing frame according to one of Claims 1 to 4, **characterized in that** openings (21) through which parts (19) of the component (7) that are not intended to be covered by the moulding compound can be led are formed between the upper frame part (5) and the lower frame part (3).

6. Method for covering a component with a moulding compound using a sealing frame (1) according to one of Claims 1 to 5, comprising the following steps:
(a) placing the component (7) in the upper frame part (5) and the lower frame part (3) and connecting the upper frame part (5) and the lower frame part (3) to form the sealing frame (1), so that there forms a cavity (25) which is enclosed by the component (7) and the upper frame part (5),
(b) introducing a moulding compound into the cavity (25) and curing the moulding compound to form a covering (29),
(c) removing the sealing frame (1) by disconnecting the upper frame part (5) and the lower frame part (3) and taking out the component (7).

7. Method according to Claim 6, **characterized in that** the moulding compound is a low-pressure moulding compound, in particular an epoxy low-pressure moulding compound.

8. Method according to Claim 6 or 7, **characterized in that**, for introducing the moulding compound, the component (7) is placed together with the sealing frame (1) in a casting mould.

9. Method according to one of Claims 6 to 8, **characterized in that** the component (7) and the sealing frame (1) are heated in the casting mould, so that the upper frame part (5) and the lower frame part (3) expand and there forms between the sealing frame (1) and the component (7) a connection that is sealed against the moulding compound.

10. Method according to one of Claims 6 to 9, **characterized in that** the component (7) comprises a populated printed circuit board (11).

11. Method according to one of Claims 6 to 10, **characterized in that** the component (7) comprises a lead frame (9).

12. Method according to Claim 11, **characterized in that** parts of the lead frame (9) that are not intended to be covered by the moulding compound are led through openings (21) between the upper frame part (5) and the lower frame part (3) of the sealing frame (1), wherein the upper frame part (5) and the lower frame part (3) enclose in a sealing manner the parts (19) that are led through the openings (21), so that no moulding compound can escape through the openings (21).

## Revendications

1. Encadrement d'étanchéité destiné à délimiter une surface d'un composant (7) qui doit être couverte par une pâte de moulage,
l'encadrement comprenant une partie supérieure d'encadrement (5) et une partie inférieure d'encadrement (3) qui peuvent être reliées l'une à l'autre de manière libérable,
le composant (7) qui doit être recouvert par la pâte de moulage pouvant être entouré par la partie supérieure d'encadrement (5) et la partie inférieure d'encadrement (3) de telle sorte qu'une cavité (25) formée de l'encadrement d'étanchéité (1) et du composant (7) pour la pâte de moulage apportée de la cavité (25) soit rendue étanche.

2. Encadrement d'étanchéité selon la revendication 1, **caractérisé en ce que** l'encadrement d'étanchéité (1) est formé d'une matière synthétique thermoplastique qui ne se lie pas à la pâte de moulage.

3. Encadrement d'étanchéité selon la revendication 2, **caractérisé en ce que** la matière synthétique thermoplastique est un copolymère de perfluoroalcoxy.

4. Encadrement d'étanchéité selon l'une des revendications 1 à 3, **caractérisé en ce que** l'encadrement d'étanchéité (1) présente des pinces de fermeture (23) par lesquelles la partie supérieure d'encadrement (5) et la partie inférieure d'encadrement (3) peuvent être reliées l'une à l'autre.

5. Encadrement d'étanchéité selon l'une des revendications 1 à 4, **caractérisé en ce que** des passages (21) par lesquels les parties (19) du composant (7) qui ne doivent pas être recouvertes par la pâte de moulage peuvent être passées sont formées entre la partie supérieure d'encadrement (5) et la partie inférieure d'encadrement (3).

6. Procédé pour recouvrir un composant d'une pâte de moulage en recourant à un encadrement d'étanchéité (1) selon l'une des revendications 1 à 5, le procédé comportant les étapes suivantes :
(a) le composant (7) est inséré dans la partie supérieure d'encadrement (5) et la partie inférieure d'encadrement (3), et la partie supérieure (5) et la partie inférieure (3) de l'encadrement sont reliées à l'encadrement d'étanchéité (1) de manière à former une cavité (25) qui est entourée par le composant (7) et la partie supérieure (5) de l'encadrement,
(b) une pâte de moulage est insérée dans la cavité (25) et la pâte de moulage est durcie pour former un recouvrement (29) et
(c) l'encadrement d'étanchéité (1) est enlevé par libération de la liaison entre la partie supérieure (5) et la partie inférieure (3) de l'encadrement et l'enlèvement du composant (7).

7. Procédé selon la revendication 6, **caractérisé en ce que** la pâte de moulage est une pâte de pressage à basse pression et en particulier une pâte de pressage à basse pression en époxyde.

8. Procédé selon les revendications 6 ou 7, **caractérisé en ce que** le composant (7) est inséré en même temps que l'encadrement d'étanchéité (1) dans un outil de moulage pour placer la pâte de moulage.

9. Procédé selon l'une des revendications 6 à 8, **caractérisé en ce que** le composant (7) et l'encadrement d'étanchéité (1) sont chauffés dans l'outil de moulage de telle sorte que le cadre supérieur (5) de l'encadrement et le cadre inférieur (3) de l'encadrement se dilatent et qu'une liaison étanche vis-à-vis de la pâte de moulage s'établisse entre l'encadrement d'étanchéité (1) et le composant (7).

10. Procédé selon l'une des revendications 6 à 9, **caractérisé en ce que** le composant (7) comporte une carte de circuit (11) équipée de composants.

11. Procédé selon l'une des revendications 6 à 10, **caractérisé en ce que** le composant (7) comprend une grille estampée (9).

12. Procédé selon la revendication 11, **caractérisé en ce que** les parties de la grille estampée (9) qui ne doivent pas être recouvertes par la pâte de moulage sont passées par des passages (21) prévus entre la partie supérieure (5) et la partie inférieure (3) de l'encadrement d'étanchéité (1), la partie supérieure (5) et la partie inférieure (3) de l'encadrement enfermant hermétiquement les parties (19) qui sont passées par les passages (21) de telle sorte que la pâte de moulage ne puisse sortir par les passages (21).
